# EUROPEAN PATENT SPECIFICATION

(11) **EP 3 555 980 B1**
(45) Date of publication and mention of the grant of the patent: **17.08.2022**
(21) Application number: 17828877.5
(22) Date of filing: 15.12.2017
(51) Int. Cl.: H02G 5/00, H02B 1/21, B32B 15/08, H05K 3/46

(54) **METHOD OF MANUFACTURING A MULTI-PHASE BUSBAR AND ARRANGEMENT FOR ARRANGEMENT FOR CARRYING OUT THE METHOD**
VERFAHREN ZUR HERSTELLUNG EINER MEHRPHASIGEN BUSSCHIENE UND ANORDNUNG ZUR DURCHFÜHRUNG DES VERFAHRENS
PROCÉDÉ DE FABRICATION D'UNE BARRE OMNIBUS POLYPHASÉE ET AGENCEMENT POUR AGENCEMENT DE LA MISE EN OEUVRE DU PROCÉDÉ

(30) Priority: 19.12.2016 EP 16205013; 19.12.2016 EP 16205020; 19.12.2016 EP 16205023
(43) Date of publication of application: 23.10.2019
(73) Proprietor: ABB Schweiz AG, 5400 Baden (CH)
(72) Inventor: VELTHUIS, Rudi, 79787 Lauchringen (DE); KRIVDA, Andrej, 5430 Wettingen (CH); DUDEK, Krzysztof, 30-392 Krakow (PL); MICHALIK, Adam, 32-087 Bibice (PL); ROCKS, Jens, 8807 Freienbach (CH)
(74) Representative: Kesselhut, Wolf
(86) International application number: PCT/EP2017/083060
(87) International publication number: WO 2018/114687

(56) References cited:
- WO-A1-2012/177826
- US-A- 4 358 633
- US-A1- 2012 077 359
- US-A1- 2014 116 751

## Description

The invention is related to a method of manufacturing a multi-phase busbar and an arrangement for carrying out the method according to claims 1 and 9.

Multi-phase busbars are used in switchboards to conduct and distribute alternating electrical current to different electrical devices which are usually installed in switch gear cabinets. In order to provide for the possibility to conduct all three phases or even more phases of an alternating current in a single busbar, multi-phase busbars have been developed which comprise a base layer and a cover layer of electrically insulating material between which two or more layers of conducting sheet metal, in particular copper, are arranged that are electrically insulated from each other by means of insulating intermediate layers.

An afore-described busbar in which the different layers are laminated to each other by means of liquid resin is described in DE 10 2005 015 945 B4 of the applicant. The laminated busbar has the advantage that it is compact and does not tend to delaminate due to repellant forces which are generated by the alternating electric currents that are conducted in the different conducting layers for each phase and which in case of a short circuit can be in the range of several thousand ampere (kA).

One problem of the busbars as described in DE 10 2005 015 945 B4 are the costs involved in the lamination process itself in which the different layers are bond to each other by means of a liquid resin, like epoxy resin, which is applied to the upper and lower side of each layer and cured afterwards. As the laminating resins used for the laminating process are usually toxic and are said to cause allergic reactions, specific safety precautions for the staff are required in the production process which significantly raise the production costs. Another problem of the busbars described in DE 10 2005 015 945 B4 can be seen in that the laminating resin has to be cured before apply a next layer, which significantly extends the production time in total.

Patent documents US2014/116751A1 and US4358633A disclose further busbars and busbar manufacturing methods.

Accordingly, it is an object of the present invention to provide for a method which allows to produce a multi-phase busbar at reduced production times and efforts.

This object is achieved by a method as claimed in claim 1.

Another object of the present invention is to provide an arrangement for carrying out the method.

This object is achieved by an arrangement as claimed in claim 9.

Further objects of the invention are described in the dependent claims.

The invention has the advantage that the production efforts and costs can be kept low due to an effective handling of the accomplished busbars. Moreover, there exists the possibility to carry out at least the casting process and the demoulding of the final product automatically, e.g. by means of a robot or another specialized handling device. This avoids the necessity that any human may get into contact with the resin and the toxic fumes emitted therefrom or from the freshly cast products.

Moreover, the invention has the advantage that no complex mold and no tight sealing around the pins is required, as the pins can be arranged in an upward orientation in the mold while the mold is filled up with liquid resin.

Furthermore, the casting can be performed without the use of vacuum if an appropriate resin is used, and in general, the efforts and costs for assembling the busbar are lower, because there are no additional assembling steps required except the positioning of the connection areas of the conduction layers in the holding elements and positioning the arrangement in the mold.

According to another object of the invention, the method is characterized by providing a recess between an inner surface of the mold and the lateral edges of the first and second conducting layers, wherein the recess allows the resin to flow into spaces which are defined between the first and the second conducting layers and/or between the lateral edges of the first and second conducting layers and at least one of the inner surfaces of the mold. This provides for the advantage that air which is entrapped in the liquid resin can evade through the recesses.

In a preferred embodiment of the method, each of the first and second holding elements comprises a block shaped base body with smooth side surfaces which are located between the receiving pockets. After curing the resin each of the side surfaces of the holding elements defines a side surface of a respective electrically insulating resin layer which separates two conducting layers in the final multi-phase busbar, from which the connecting areas of the at least first and second conducting layers project.

In order to more easily remove excess air from the mold and the resin while filling in and/or curing the resin, the mold may be covered with a lid, and the interior space of the mold may be connected to a vacuum source.

Additionally or alternatively, the resin may be exposed to ultrasonic vibrations while curing the resin and/or the mold may be pivoted back and forth sideways to remove air from the liquid resin which is entrapped between two of the conducting layers.

Moreover, in order to provide for an even an parallel alignment of the conducting layers relative to each other in the final busbar, a supporting force may be applied at least to the first conducting pin and/or second conducting pin and also to the further conducting pins of additional conducting layers. The supporting force may be provided by a clamping and holding means which grips the top of each upwardly oriented conducting pin and pulls it upwards so as to compensate for a bending of the conducting layers due to their own weight when held between the first and second holding element.

According to another object of the invention, the first and second holding elements are preferably coated with or made from a resin repelling material, in order to ease the removal of the holding elements and the final busbar from the mold.

To do so, the first and second holding elements may be made of and/or coated with silicone rubber. Additionally, a known separating agent may be sprayed on the surfaces of the holding elements, which are in contact with the resin.

A first holding element has a base body with at least two slot shaped receiving pockets formed therein for receiving a first connecting area of a first and second conducting layer. The first and the second base bodies may be identical in shape and have the form of a block or an ashlar. The block shaped base bodies may have smooth or even side surfaces as described herein before which are located between the receiving pockets. Each of the smooth side surfaces defines a resin forming surface which corresponds to a side surface of the insulating layer which is arranged between two conducting layers in the final busbar.

Moreover, the arrangement further includes a mold which is adapted to contain the first holding element and the second holding element and at least a first and a second, but preferably four conducting layers arranged there between with its first and second connecting areas received in the receiving pockets of the respective holding element.

In a preferred embodiment of the invention, the first holding element comprises a first and a second opposing lateral surface which is located at a distance from the first receiving pockets. In the same way, the second holding element comprises a first and a second opposing lateral surface which is located at a distance from the second receiving pockets of the second holding element. Due to the distances at which the opposing lateral surfaces of the first and second holding elements are located from the lateral edges of the associated receiving pockets, a recess or space is defined which provides for a rear and a back insulating layer covering the lateral edges of the conducting layers when the arrangement is inserted into a mold having an ashlar - shaped interior space.

The invention is hereinafter described with reference to the accompanying drawings. In the drawings
- Fig. 1: is a schematic view of an exemplary embodiment of a multi-phase busbar of the invention for distributing electric energy in a switch gear assembly or a switch gear cabinet having four conducting layers,
- Fig. 2: is a schematic view of the four conducting layers and conducting pins for a 3-phase busbar according to the invention before arranging the conducting layers in the holding elements,
- Fig. 3: is a schematic semi-transparent view of the conducting layers of Fig. 2 after positioning the connecting areas in the receiving pockets of the holding elements,
- Fig. 4a: is a cross sectional view of the arrangement of holding elements and the conducting layers of Fig. 3 before positioning the same in a mold,
- Fig. 4b: is a schematic side view of the arrangement of holding elements and conducting layers of 4a after positioning the same in a mold,
- Fig. 4c: is a schematic side view of the arrangement of the mold and the holding elements and conducting layers of Fig. 4b while filling in liquid resin,
- Fig. 4d: is a schematic top view of the mold of Fig. 4c indicating the recess between the inner lateral side walls of the mold and the lateral side edges of the conducting layers,
- Fig. 4e: is a schematic side view of the mold of Figs. 4b to 4d after completely filling up the resin to a predetermined level, and
- Fig. 4f: is a cross sectional view of the assembled busbar after removing the mold and holding elements.

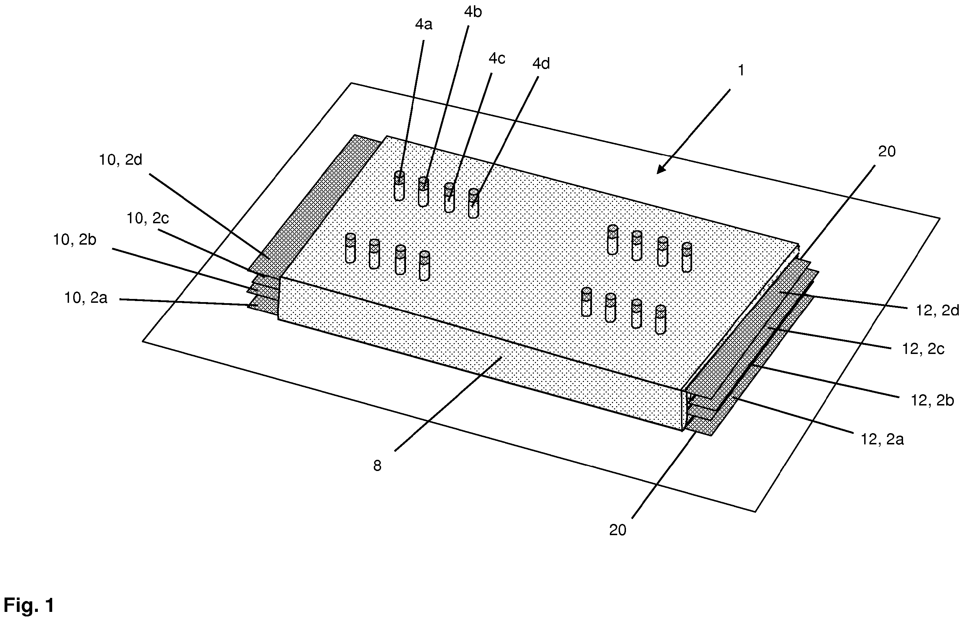

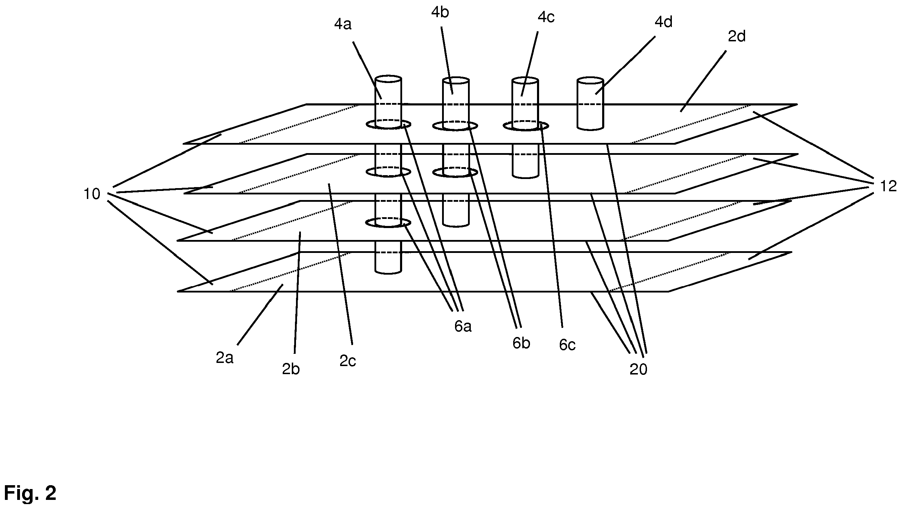

As it is shown in Fig. 1 and 2, a multi-phase busbar 1 for conducting electric energy in a switch gear or a switch gear cabinet (not shown), comprises a first conducting layer 2a which is made of a sheet metal, preferably copper or aluminium, which can have a thickness of 0.5 mm to 5 mm or more. The first conducting layer 2a comprises at least one first conducting pin 4a, which extends in a direction perpendicular to the first conducting layer 2a and which is either integrally formed with the conducting layer 2a when manufacturing the same or may be soldered or mechanically attached to the sheet metal by screwing or clamping.

For the reason of simplicity, the multi-phase busbar of the invention shown in Fig. 1 which preferably comprises a plurality of sets of four connecting pins 4a to 4c for connecting different electrical devices to the three phases and protective earth of an electric power supply in a switchboard of switchboard cabinet, is hereinafter described with reference to an embodiment shown in Figs. 2 to 4 having only four connecting pins 2a to 2d.

As can be seen from the cross sectional view of Fig. 2, the busbar 1 comprises at least one second conducting layer 2b which is preferably made of the same sheet metal as the first conducting layer 2a. In addition, there are preferably provided at least two further conducting layers 2d and 2e with conducting pins 4b to 4e mounted thereat. The conducting pins 4a to 4c extend through associated openings 6a, 6b and 6c as it is shown in Figs 2 to 4e.

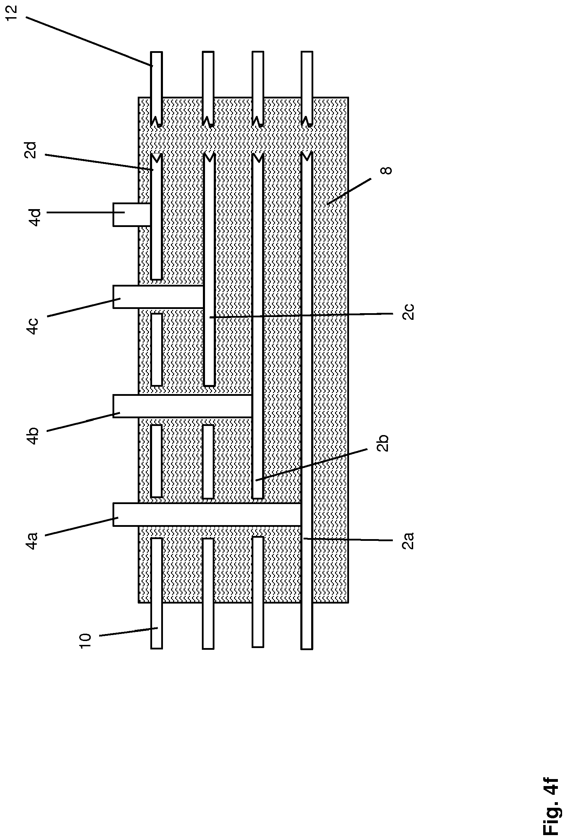

Referring to Figs. 1 and 4f, the conducting layers 2a to 2d are arranged at a distance from each other and are mechanically interconnected to each other and electrically insulated from each by cured resin 8, e.g. unsaturated polyester resin or epoxy resin, which is arranged in the spaces between the conducting layers 2a to 2d. The resin 8 preferably also covers the top, bottom and side surfaces of the conducting layers 2a to 2d as it is indicated in Fig. 1 and 4f, in order to electrically insulate the conducting layers against flashovers or sparking.

From Fig. 1 and 4f it can be taken that each of the conducting layers 2a to 2d comprises a first and second connection area 10, 12 which is located at the opposing end portions of each conducting layer and serves as a terminal for electrically connecting an associated conducting layer 2a to 2d to a corresponding phase and protective earth of an electric power supply which is not shown in the drawings. Alternatively, the connection areas 10, 12 which are also referred to as shipping splits may also be used to electrically connect the busbar 1 to a connecting area 10, 12 of a further multi-phase busbar (not shown).

The method of manufacturing a busbar 1 according to the present invention will now be described with reference to an exemplary embodiment having at least two conducting layers 2a, 2d which represent the minimum configuration of a multi-phase busbar.

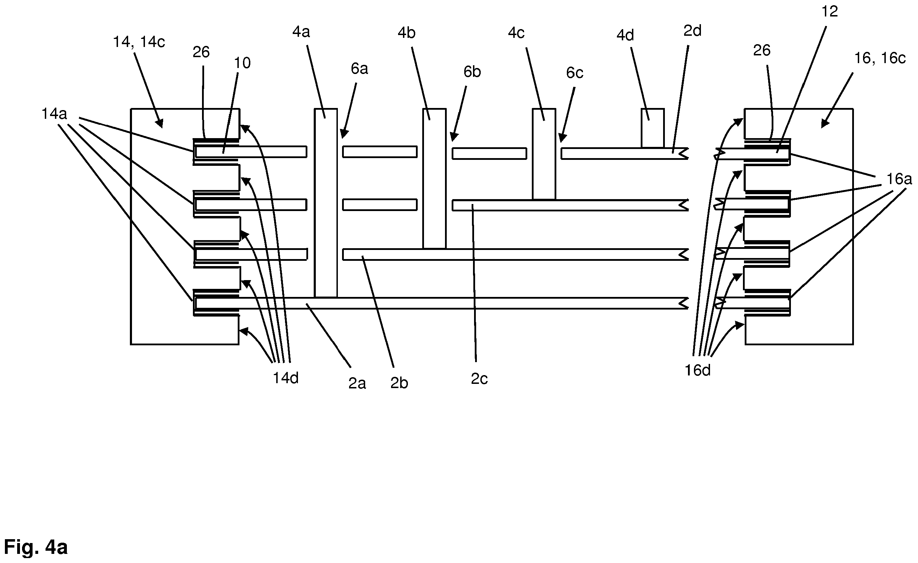

As it is shown in Figs. 2 to 4f, a busbar 1 described herein before is preferably manufactured by a method comprising the following method steps:
In a first step shown in Fig. 2, the even conducting layers 2a to 2d with the conducting pins 4a to 4d are arranged in parallel to each other such that the respective conducting pins 4a to 4c extend through the openings 6a to 6c formed in the corresponding conducting layer 2b, 2c, 2d.

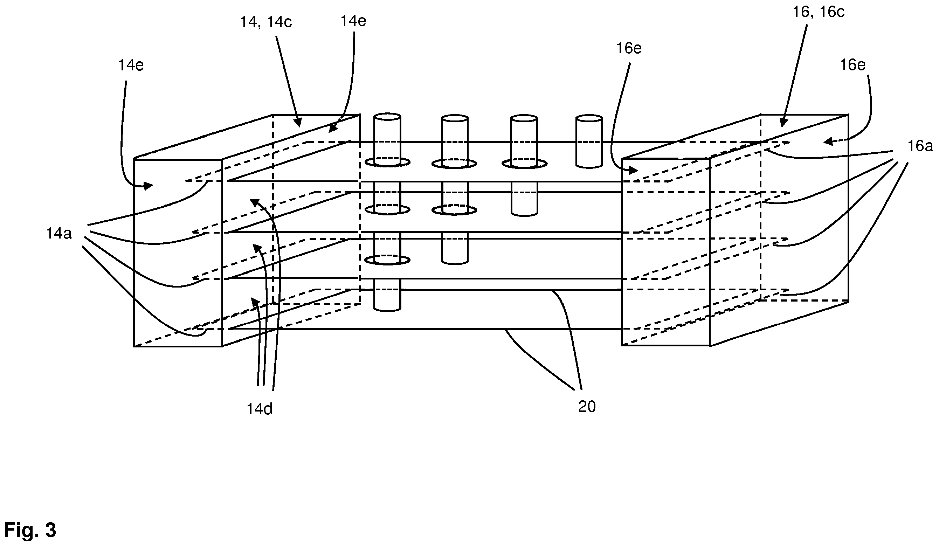

In a next step, which is indicated by Fig. 3, a first and a second holding element 14, 16 are located near the connecting areas 10, 12 of the conducting layers 2a to 2d. Each holding element 14, 16 comprises a base body 14c, 16c, in which a set of slot shaped receiving pockets 14a, 16a is formed. The receiving pockets 14a to 16a are located at a distance to each other which corresponds to the distance between two neighboring conducting layers 2 in the assembled busbar 1. The openings of the receiving pockets 14a, 16a have a shape which corresponds to the rectangular shape of the cross section of the connecting area 10, 12 of the associated conducting layer 2a to 2d, such that a connecting area 10, 12 is received in a receiving pocket in a tightly fitting manner when pushing the holding elements 14, 16 towards each other, so as to seal the interior of the pocket 14a, 16a against an entry of liquid resin 8.

In order to improve the sealing against an entry of liquid resin 8, there may also be provided a sealing element 26 e.g. a rubber sealing ring or simmering type of sealing ring, which may be received in a notch or the like (not shown) of a base body 14c, 16c if the base body is made from a non-resilient material, e.g. plastics or fiber glass or wood or the like as it is indicated in Fig. 4a. Alternatively, the base body 14c, 16c can be formed of a flexible material like rubber or silicone rubber in which the openings of the slot shaped receiving pockets 14a, 16a are formed with a cross section that is slightly smaller than the cross section of a corresponding connecting area 10, 12 received therein. In this case the resilient material of the base body 14c, 16c itself which may also be coated with a known separating agent for polymeric resins, takes over the sealing function of the sealing element 26.

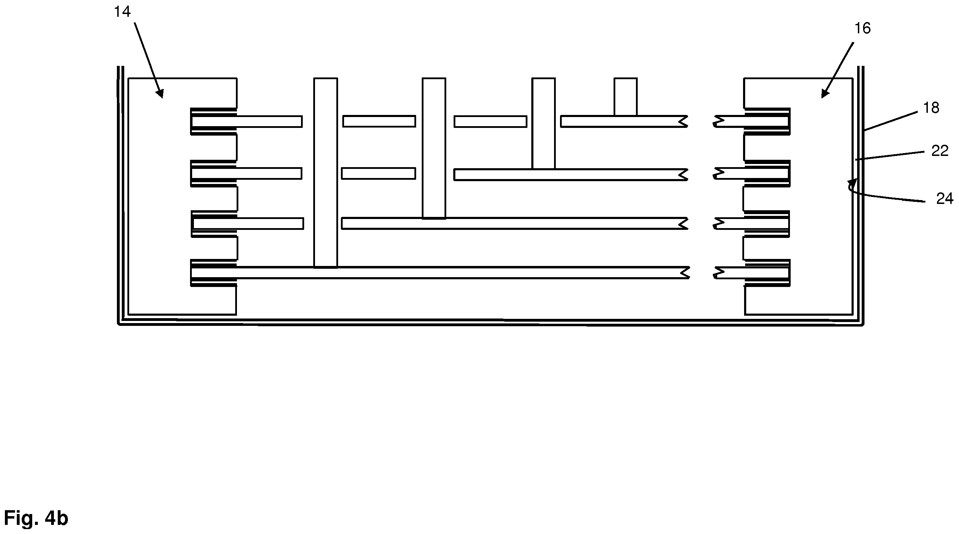

After the first connecting areas 10 of the conducting layers 2a, 2b and also 2c and 2d have been received in the first slot shaped receiving pockets 14a of said first holding element 14 and the second connecting areas 12 of the conducting layers 2a to 2d have been inserted into the slot shaped receiving pockets 16a, 16b of the second holding element 16 (Fig. 4a), the assembly comprising the first and second holding elements 14, 16 and the conducting layers 2a to 2d arranged there between is inserted into a mold 18, as it is shown in Fig. 4b. The mold 18 may be made of a resin repelling plastic material or a metal like aluminum or steel and may have side walls which can be removed and joined to the neighboring side walls of the mold 18 separately, in order to ease the insertion of the assembly and the removal of the final bus bar 1 after curing the resin 8.

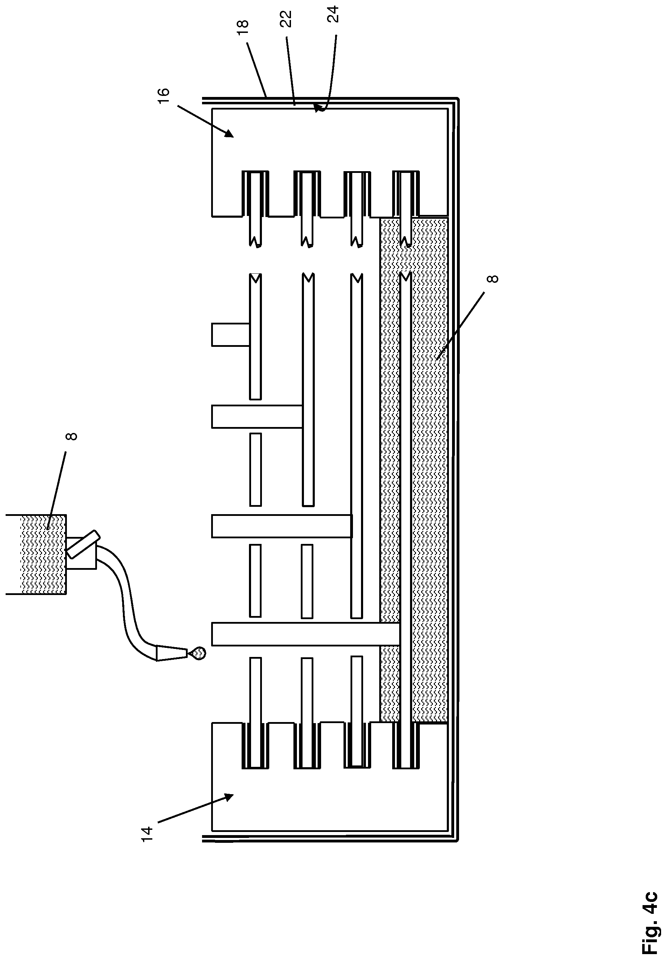

As a next step (Fig. 4c), the mold 18 is filled up with liquid curable resin 8, e.g. a known two component epoxy resin or polyester resin which may be self-curing after mixing the components or may be cured by applying heat to the mold 18.

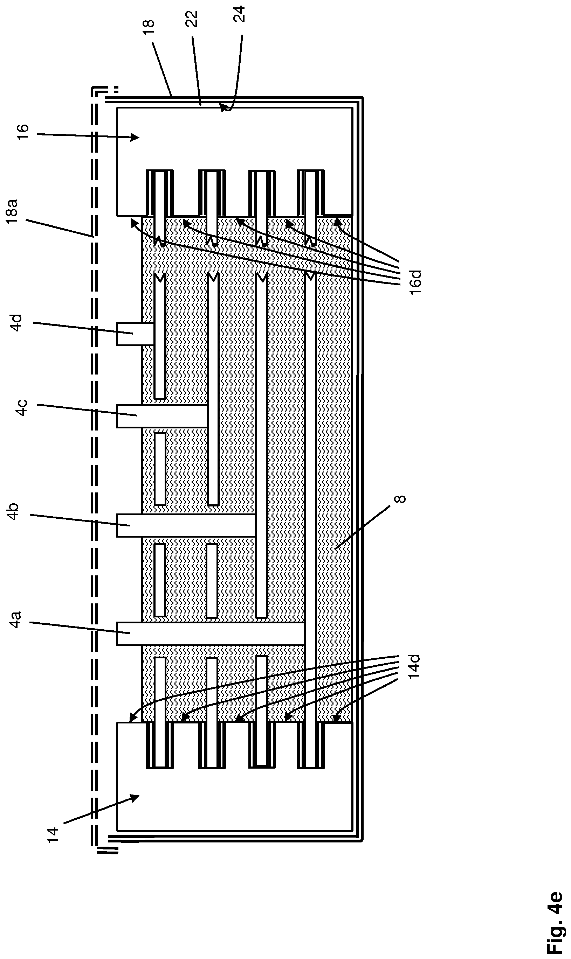

After the mold 18 has been filled up with liquid resin 8 to the desired level which lies at a distance above the upper surface of the upper most conducting layer 2d, the mold may be covered by a lid 18a as it is indicated in Fig. 4e and the interior space of the mold 18 may be connected to a vacuum source (not shown) for removing excess air from the resin 8 while filling in and/or curing said resin.

After curing the resin 8, the interconnected sandwich of conducting layers 2a to 2d and electrically insulating resin layers which are formed there between and at the top, bottom and lateral side surfaces thereof, is removed together with the holding elements 14, 16 from the mold 18.

As a final step, the holding elements 14, 16 which are attached to the connecting areas 10, 12 of each conducting layer 2a to 2d and protect the electrically conducting surface thereof against residues of resin 8 are pulled off from the connecting areas/shipping blinds 10, 12, in order to reveal the final busbar 1 (Fig. 4f).

In order to avoid a firm bonding between the cured resin at the outer surfaces of the busbar 1 and the inner surfaces of the mold 18 and thereby ease the removal of the busbar 1 from the mold 18, the inner surfaces of the mold 18 and/or the slot shaped receiving pockets 14a, 16a and the outer surfaces of the holding elements 14, 16 are preferably entirely covered with a known separating agent for epoxy or polyester resins, which may be sprayed onto the associated surfaces.

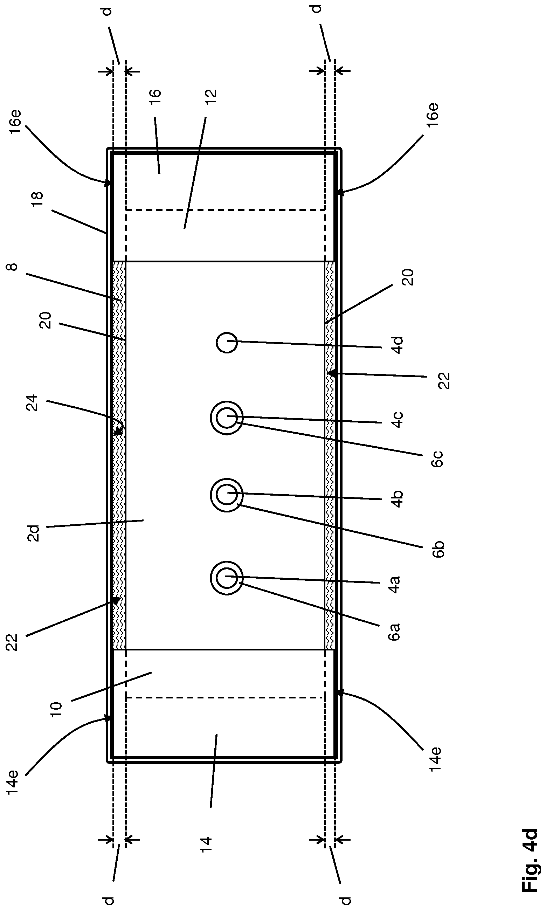

As it can be further seen from Fig. 4d, a recess 22 is formed between an inner surface 24 of the mold 18 and the lateral edges 20 of the first and second conducting layers 2a, 2b. The recess 22 allows the resin 8 to flow into the spaces which are defined between each of the conducting layers 2a to 2d and/or between the lateral edges 24 of the conducting layers 2a to 2d and the associated inner surface 24 of the mold 18. The resin 8 which fills out the spaces defined by the recesses 22 at the front and at the rear side of the conducting layer of Fig. 4f each provides for an insulating front and back layer, respectively, which electrically insulates the lateral edges 20 of the conducting layers 2a to 2d in the final busbar 1, as it is indicated in Fig. 1.

As it can further be seen from Figs. 3 and 4a, each of the first and second holding elements 14, 16 preferably comprises a block shaped base body 14c with smooth side surfaces 14d, 16d which are located between the receiving pockets 14a, 14b. After curing the resin, the side surfaces 14d, 16d define side surfaces of the multi-phase busbar from which the connecting areas 10, 12 of the conducting layers 2a to 2d project, as it is illustrated in Fig. 4f.

The first and second holding elements 14, 16 may further comprise a first and a second opposing lateral surface 14e, 16e which are located at a distance d from the associated receiving pockets, as it is shown in Fig. 3 and 4d. Due to the distances d at which the opposing lateral surfaces 14e, 16e of the first and second holding elements 14, 16 are located from the lateral edges of the associated receiving pockets 14a, 16a, a recess or space 22 is defined which provides for a rear and a back insulating layer covering the lateral edges 20 of the conducting layers 2a to 2d when the arrangement is inserted into a mold 18 having an ashlar-shaped interior space.

### Listing of reference numerals

- 1: busbar
- 2a: first conducting layer
- 2b: second conducting layer
- 2c: third conducting layer
- 2d: forth conducting layer
- 4a: first conducting pin
- 4b: second conducting pin
- 4c: third conducting pin
- 4d: forth conducting pin
- 6a: first opening
- 6b: second opening
- 6c: third opening
- 8: resin
- 10: first connection area
- 12: second connection area
- 14: first holding element
- 14a: slot shaped receiving pockets
- 14c: first block shaped base body
- 14d: smooth side surface between receiving pockets
- 14e: opposing lateral surfaces of first holding element
- 16: second holding element
- 16a: slot shaped receiving pockets
- 16c: second block shaped base body
- 16d: smooth side surface between receiving pockets
- 16e: opposing lateral surfaces of second holding element
- 18: mold
- 18a: lid of mold
- 20: lateral edges of conducting layers
- 22: recess
- 24: inner surfaces of mold
- 26: sealing element

## Claims

1. Method of manufacturing a multi-phase busbar (1) comprising providing a first conducting layer (2a) made of a sheet metal, a first conducting pin (4a) mounted to said first conducting layer (2a) which extends in a direction perpendicular to the first conducting layer (2a), a second conducting layer (2b) made of a sheet metal, said second conducting layer (2b) comprising a first opening (6a) through which said first conducting pin (4a) projects, a second conducting pin (4b) which extends in a direction parallel to said first conducting pin (4a), wherein the first and second conducting layers (2a, 2b) are mechanically interconnected to each other and electrically insulated from each by cured resin (8), and wherein each of said first and second conducting layers (2a, 2b) comprises a first and second connection area (10, 12) at its opposing end portions for electrically connecting said conducting layer (2a, 2b) to an electric power supply and/or a connecting area (10, 12) of a further multi-phase busbar (1), wherein the method further comprises the steps of providing liquid curable resin (8) and providing a mold (18) with a recess (22) formed between an inner surface (24) of the mold (18) and the lateral edges (20) of the first and second conducting layers (2a, 2b), and:
- providing a first and a second holding element (14, 16), each having a base body (14c) with slot shaped receiving pockets (14a; 16a) formed therein for receiving the first and second connecting areas (10, 12) of each one of said first and second conducting layers (2a, 2b)
- inserting said first connecting areas (10) of said first and second conducting layers (2a, 2b) in said first slot shaped receiving pockets (14a) of said first holding element (14),
- inserting said second connecting areas (12) of said first and second conducting layer (2a, 2b) in said slot shaped receiving pockets (16a, 16b) of said second holding element (16),
- placing said first and second holding elements (14, 16) with said first and second conducting layers (2a, 2b) arranged there between in the mold (18),
- filling up said mold (18) with said liquid curable resin (8),
- curing said liquid resin (8), and
- removing said holding elements (14, 16) from said connecting areas (10, 12).

2. Method of claim 1, **characterized in that** said recess allows said resin (8) to flow into spaces defined between said first and second conducting layers (2a,2b) and/or between the lateral edges (24) of said first and second conducting layers and at least one of the inner surfaces (24) of said mold (18).

3. Method according to any of the preceding claims **characterized in that** each of said first and second holding elements (14, 16) comprises a block shaped base body (14c) with smooth side surfaces (14d, 16d) which are located between said receiving pockets (14a, 14b), wherein said side surfaces (14d, 16d) after curing said resin (8) define side surfaces of said multi-phase busbar (1) from which the connecting areas (12) of the first and second conducting layers (2a, 2b) project.

4. Method according to any of the preceding claims **characterized in that** said mold (18) is covered with a lid (18a) and the interior space of said mold (18) is connected to a vacuum source for removing excess air from said liquid resin while filling in and/or curing said resin (8).

5. Method according to any of the preceding claims **characterized in that** said resin (8) is exposed to ultrasonic vibrations while curing said resin (8) and/or said mold (18) is pivoted back and forth sideways to remove encapsulated air from said liquid resin (8) in said mold (18).

6. Method according to any of the preceding claims **characterized in that** a supporting force is applied to said first conducting pin (4a) and/or said second conducting pin (4b) to support said first and/or second conducting layer (2a, 2b) while curing said resin (8) in said mold (18).

7. Method according to any of the preceding claims **characterized in that** said first and second holding elements (14, 16) are coated with or made from a resin repelling material.

8. Method of claim 7 **characterized in that** said first and second holding elements (14, 16) are made of and/or coated with silicone rubber.

9. Arrangement for carrying out the method according to any of the preceding claims comprising
- a first conducting layer (2a) made of a sheet metal, a first conducting pin (4a), mounted to said first conducting layer (2a), which extends in a direction perpendicular to the first conducting layer, a second conducting layer (2b) made of a sheet metal, said second conducting layer comprising a first opening (6a), through which said first conducting pin projects, a second conducting pin (4b) which extends in a direction parallel to said first conducting pin;
- a first holding element (14) having a base body (14c) with at least two slotshaped receiving pockets (14a, 14b) formed therein which are adapted to receive a first connecting area (10) of said first and second conducting layers (2a, 2b) made of a sheet metal,
- a second holding element (16) having a base body (16c) with at least two slotshaped receiving pockets (16a, 16b) formed therein which are adapted to receive a second connecting area (12) of said first and second conducting layers (2a, 2b), wherein each of said first and second conducting layers (2a, 2b) comprises said first and second connection area (10, 12) at its opposing end portions for electrically connecting said conducting layer (2a, 2b) to an electric power supply and/or a connecting area (10, 12) of a further multi-phase busbar (1), and
- a mold (18) which is adapted to contain said first holding element (14) and said second holding element (16) and said first and a second conducting layer (2a, 2b) arranged there in between with its first and second connecting areas (10, 12) inserted in said receiving pockets (10,12), wherein a recess (22) is formed between an inner surface (24) of the mold (18) and the lateral edges (20) of the first and second conducting layers (2a, 2b),
the mold (18) is adapted to be filled up with a liquid curable resin (8), and said first and second holding elements (14, 16) being adapted to be removed from said connecting areas (10, 12) after curing said liquid curable resin (8).

10. Arrangement of claim 9, **characterized in that** said first holding element (14) comprises a first and a second opposing lateral surface (14e) which is located at a distance (d) from said first receiving pockets (10) and that said second holding element (14) comprises a first and a second opposing lateral surface (16e) which is located at a distance (d) to said second receiving pockets (10) of said second holding element (16),

11. Arrangement of claim 9 or 10, **characterized in that** each of said first and second holding elements (14, 16) comprises a block shaped base body (14c, 16c) with smooth side surfaces (14e, 16e) which are located between said receiving pockets (14a, 14b), each of said smooth side surfaces (14e, 16e) defining a resin forming surface.

12. Arrangement of any of claims 9 to 11, **characterized in that** each receiving pocket (14a) of said first holding element (14) and/or each receiving pocket (16a) of said second holding element (16) is sealed by a sealing element (26).

13. Multi-phase busbar (1) comprising a first conducting layer (2a) made of a sheet metal, a first conducting pin (4a) mounted to said first conducting layer (2a) which extends in a direction perpendicular to the first conducting layer (2a), a second conducting layer (2b) made of a sheet metal, said second conducting layer (2b) comprising a first opening (6a) through which said first conducting pin (4a) projects and a second conducting pin (4b) which extends in a direction parallel to said first conducting pin (4a), wherein the first and second conducting layers (2a, 2b) are mechanically interconnected to each other and electrically insulated from each by cured resin (8), and wherein each of said first and second conducting layers (2a, 2b) comprises a first and second connection area (10, 12) at its opposing end portions for electrically connecting said conducting layer (2a, 2b) to an electric power supply and/or a connecting area (10, 12) of a further multi-phase busbar (1), wherein the multi-phase busbar (1) is produced or built by applying the method according to one of the preceding claims 1 to 8.

## Patentansprüche

1. Verfahren zur Herstellung einer mehrphasigen Sammelschiene (1), umfassend Bereitstellen einer ersten leitfähigen Schicht (2a), die aus einem Metallblech gefertigt ist, eines ersten leitfähigen Stifts (4a), der an der ersten leitfähigen Schicht (2a) montiert ist, der sich in einer Richtung senkrecht zu der ersten leitfähigen Schicht (2a) erstreckt, einer zweiten leitfähigen Schicht (2b), die aus einem Metallblech gefertigt ist, wobei die zweite leitfähige Schicht (2b) eine erste Öffnung (6a) umfasst, durch die der erste leitfähige Stift (4a) ragt, einen zweiten leitfähigen Stift (4b), der sich in einer Richtung parallel zu dem ersten leitfähigen Stift (4a) erstreckt, wobei die ersten und zweiten leitfähigen Schichten (2a, 2b) mechanisch miteinander verbunden und elektrisch durch gehärtetes Harz (8) voneinander isoliert sind, und wobei jede der ersten und zweiten leitfähigen Schichten (2a, 2b) eine erste und zweite Anschlussfläche (10, 12) an ihren einander gegenüberliegenden Endabschnitten umfasst, um die leitfähige Schicht (2a, 2b) elektrisch mit einer elektrischen Stromquelle und/oder einer Anschlussfläche (10, 12) einer weiteren mehrphasigen Sammelschiene (1) zu verbinden, wobei das Verfahren des Weiteren die Schritte des Bereitstellens von flüssigem härtbarem Harz (8) und Bereitstellen einer Form (18) mit einer Aussparung (22) umfasst, die zwischen einer inneren Oberfläche (24) der Form (18) und den lateralen Rändern (20) der ersten und zweiten leitfähigen Schichten (2a, 2b) gebildet ist, und:
- Bereitstellen eines ersten und eines zweiten Halteelements (14, 16), das jeweils einen Basiskörper (14c) mit darin gebildeten schlitzförmigen Aufnahmetaschen (14a; 16a) aufweist, um die ersten und zweiten Anschlussflächen (10, 12) jeder der ersten und zweiten leitfähigen Schichten (2a, 2b) aufzunehmen,
- Einführen der ersten Anschlussflächen (10) der ersten und zweiten leitfähigen Schichten (2a, 2b) in die ersten schlitzförmigen Aufnahmetaschen (14a) des ersten Halteelements (14),
- Einführen der zweiten Anschlussflächen (12) der ersten und zweiten leitfähigen Schichten (2a, 2b) in die schlitzförmigen Aufnahmetaschen (16a, 16b) des zweiten Halteelements (16),
- Platzieren der ersten und zweiten Halteelemente (14, 16) mit den dazwischen angeordneten ersten und zweiten leitfähigen Schichten (2a, 2b) in der Form (18),
- Auffüllen der Form (18) mit dem flüssigen härtbaren Harz (8),
- Härten des flüssigen Harzes (8) und
- Entfernen der Halteelemente (14, 16) von den Anschlussflächen (10, 12).

2. Verfahren nach Anspruch 1, **dadurch gekennzeichnet, dass** die Aussparung dazu eingerichtet ist, dass das Harz (8) in Räume fließt, die zwischen den ersten und zweiten leitfähigen Schichten (2a, 2b) und/oder zwischen den lateralen Rändern (24) der ersten und zweiten leitfähigen Schichten und mindestens einer der inneren Oberflächen (24) der Form (18) definiert sind.

3. Verfahren nach einem der vorhergehenden Ansprüche, **dadurch gekennzeichnet, dass** jedes der ersten und zweiten Halteelemente (14, 16) einen blockförmigen Basiskörper (14c) mit glatten Seitenoberflächen (14d, 16d) umfasst, die sich zwischen den Aufnahmetaschen (14a, 14b) befinden, wobei die Seitenoberflächen (14d, 16d) nach dem Härten des Harzes (8) Seitenoberflächen der mehrphasigen Sammelschiene (1) definieren, aus denen die Anschlussflächen (12) der ersten und zweiten leitfähigen Schichten (2a, 2b) ragen.

4. Verfahren nach einem der vorhergehenden Ansprüche, **dadurch gekennzeichnet, dass** die Form (18) mit einem Deckel (18a) bedeckt ist und der Innenraum der Form (18) mit einer Vakuumquelle verbunden ist, um überschüssige Luft aus dem flüssigen Harz zu entfernen, während das Harz (8) eingefüllt und/oder gehärtet wird.

5. Verfahren nach einem der vorhergehenden Ansprüche, **dadurch gekennzeichnet, dass** das Harz (8) Ultraschallvibrationen ausgesetzt wird, während das Harz (8) gehärtet wird, und/oder die Form (18) seitwärts hin und her geschwenkt wird, um eingeschlossene Luft aus dem flüssigen Harz (8) in der Form (18) zu entfernen.

6. Verfahren nach einem der vorhergehenden Ansprüche, **dadurch gekennzeichnet, dass** auf den ersten leitfähigen Stift (4a) und/oder den zweiten leitfähigen Stift (4b) eine Stützkraft angewendet wird, um die erste und/oder zweite leitfähige Schicht (2a, 2b) zu stützen, während das Harz (8) in der Form (18) gehärtet wird.

7. Verfahren nach einem der vorhergehenden Ansprüche, **dadurch gekennzeichnet, dass** die ersten und zweiten Halteelemente (14, 16) mit einem Harz abweisenden Material beschichtet oder daraus gefertigt sind.

8. Verfahren nach Anspruch 7, **dadurch gekennzeichnet, dass** die ersten und zweiten Halteelemente (14, 16) aus Silikonkautschuk gefertigt und/oder damit beschichtet ist bzw. sind.

9. Anordnung zur Durchführung des Verfahrens nach einem der vorhergehenden Ansprüche, umfassend:
- eine erste leitfähige Schicht (2a), die aus Metallblech gefertigt ist, einen ersten leitfähigen Stift (4a), der an der ersten leitfähigen Schicht (2a) montiert ist und sich in eine Richtung senkrecht zu der ersten leitfähigen Schicht erstreckt, eine zweite leitfähige Schicht (2b), die aus Metallblech gefertigt ist, wobei die zweite leitfähige Schicht eine erste Öffnung (6a) umfasst, durch die der erste leitfähige Stift ragt, einen zweiten leitfähigen Stift (4b), der sich in eine Richtung parallel zu dem ersten leitfähigen Stift erstreckt;
- ein erstes Halteelement (14), das einen Basiskörper (14c) mit mindestens zwei darin gebildeten schlitzförmigen Taschen (14a, 14b) aufweist, die dazu eingerichtet sind, um eine erste Anschlussfläche (10) der ersten und zweiten leitfähigen Schicht (2a, 2b) aufzunehmen, die aus Metallblech gefertigt ist,
- ein zweites Halteelement (16), das einen Basiskörper (16c) mit mindestens zwei darin gebildeten schlitzförmigen Aufnahmetaschen (16a, 16b) aufweist, die dazu eingerichtet sind, um eine zweite Anschlussfläche (12) der ersten und zweiten leitfähigen Schicht (2a, 2b) aufzunehmen, wobei jede der ersten und zweiten leitfähigen Schichten (2a, 2b) die erste und zweite Anschlussfläche (10, 12) an ihren einander gegenüberliegenden Endabschnitten umfasst, um die leitfähige Schicht (2a, 2b) elektrisch mit einer elektrischen Stromquelle und/oder einer Anschlussfläche (10, 12) einer weiteren mehrphasigen Sammelschiene (1) zu verbinden, und
- eine Form (18), die dazu eingerichtet ist, das erste Halteelement (14) und das zweite Halteelement (16) und die erste und eine zweite leitfähige Schicht (2a, 2b) zu enthalten, die dazwischen in der Weise angeordnet sind, dass ihre ersten und zweiten Anschlussflächen (10, 12) in die Aufnahmetaschen (10, 12) eingeführt sind, wobei eine Aussparung (22) zwischen einer inneren Oberfläche (24) der Form (18) und den lateralen Rändern (20) der ersten und zweiten leitfähigen Schichten (2a, 2b) gebildet ist, die Form (18) dazu eingerichtet ist, mit flüssigem härtbarem Harz (8) befüllt zu werden, und die ersten und zweiten Halteelemente (14, 16) dazu eingerichtet sind, nach dem Härten des flüssigen härtbaren Harzes (8) von den Anschlussflächen (10, 12) entfernt zu werden.

10. Anordnung nach Anspruch 9, **dadurch gekennzeichnet, dass** das erste Halteelement (14) eine erste und eine zweite entgegengesetzte laterale Oberfläche (14e) umfasst, die sich in einem Abstand (d) von den ersten Aufnahmetaschen (10) befindet, und dass das zweite Halteelement (14) eine erste und eine zweite entgegengesetzte laterale Oberfläche (16e) umfasst, die sich in einem Abstand (d) von den zweiten Aufnahmetaschen (10) des zweiten Halteelements (16) befindet.

11. Anordnung nach Anspruch 9 oder 10, **dadurch gekennzeichnet, dass** jedes der ersten und zweiten Halteelemente (14, 16) einen blockförmigen Basiskörper (14c, 16c) mit glatten Seitenflächen (14e, 16e) umfasst, die sich zwischen den Aufnahmetaschen (14a, 14b) befinden, wobei jede der glatten Seitenflächen (14e, 16e) eine Harzbildungsoberfläche definiert.

12. Anordnung nach einem der Ansprüche 9 bis 11, **dadurch gekennzeichnet, dass** jede Aufnahmetasche (14a) des ersten Halteelements (14) und/oder jede Aufnahmetasche (16a) des zweiten Halteelements (16) mit einem Dichtungselement (26) abgedichtet ist bzw. sind.

13. Mehrphasige Sammelschiene (1), umfassend eine erste leitfähige Schicht (2a), die aus einem Metallblech gefertigt ist, einen ersten leitfähigen Stift (4a), der an der ersten leitfähigen Schicht (2a) montiert ist, und sich in eine Richtung senkrecht zu der ersten leitfähigen Schicht (2a) erstreckt, eine zweite leitfähige Schicht (2b), die aus Metallblech gefertigt ist, wobei die zweite leitfähige Schicht (2b) eine erste Öffnung (6a) umfasst, durch die der erste leitfähige Stift (4a) ragt, und einen zweiten leitfähigen Stift (4b), der sich in einer Richtung parallel zu dem ersten leitfähigen Stift (4a) erstreckt, wobei die erste und zweite leitfähige Schicht (2a, 2b) mechanisch miteinander verbunden und elektrisch durch gehärtetes Harz (8) voneinander isoliert sind, und wobei jede der ersten und zweiten leitfähigen Schichten (2a, 2b) eine erste und zweite Anschlussfläche (10, 12) an ihren einander gegenüberliegenden Endabschnitten umfasst, um die leitfähige Schicht (2a, 2b) elektrisch mit einer elektrischen Stromquelle und/oder einer Anschlussfläche (10, 12) einer weiteren mehrphasigen Sammelschiene (1) zu verbinden, wobei die mehrphasige Sammelschiene (1) durch Anwenden des Verfahrens nach einem der vorhergehenden Ansprüche 1 bis 8 hergestellt oder gebaut worden ist.

## Revendications

1. Procédé de fabrication d'une barre de distribution polyphasée (1) comprenant l'obtention d'une première couche conductrice (2a) constituée d'une tôle, d'une première broche conductrice (4a) montée sur ladite première couche conductrice (2a) qui s'étend dans une direction perpendiculaire à la première couche conductrice (2a), d'une deuxième couche conductrice (2b) constituée d'une tôle, ladite deuxième couche conductrice (2b) comprenant une première ouverture (6a) à travers laquelle se projette ladite première broche conductrice (4a), d'une deuxième broche conductrice (4b) qui s'étend dans une direction parallèle à ladite première broche conductrice (4a), les première et deuxième couches conductrices (2a, 2b) étant interconnectées mécaniquement l'une à l'autre et isolées électriquement l'une de l'autre par de la résine durcie (8), et chacune desdites première et deuxième couches conductrices (2a, 2b) comprenant une première et une deuxième zone de branchement (10, 12) au niveau de ses parties d'extrémité opposées pour brancher électriquement ladite couche conductrice (2a, 2b) à une alimentation électrique et/ou une zone de branchement (10, 12) d'une autre barre de distribution polyphasée (1), le procédé comprenant en outre les étapes d'obtention de résine liquide durcissable (8) et d'obtention d'un moule (18) avec une encoche (22) formée entre une surface interne (24) du moule (18) et les bords latéraux (20) des première et deuxième couches conductrices (2a, 2b), et :
- l'obtention d'un premier et d'un deuxième élément de maintien (14, 16), chacun ayant un corps de base (14c) avec des poches de réception en forme de fente (14a ; 16a) formées à l'intérieur pour recevoir les première et deuxième zones de branchement (10, 12) de chacune desdites première et deuxième couches conductrices (2a, 2b),
- l'insertion desdites premières zones de branchement (10) desdites première et deuxième couches conductrices (2a, 2b) dans lesdites premières poches de réception en forme de fente (14a) dudit premier élément de maintien (14),
- l'insertion desdites deuxièmes zones de branchement (12) desdites première et deuxième couches conductrices (2a, 2b) dans lesdites poches de réception en forme de fente (16a, 16b) dudit deuxième élément de maintien (16),
- la mise en place desdits premier et deuxième éléments de maintien (14, 16) avec lesdites première et deuxième couches conductrices (2a, 2b) disposées entre eux dans le moule (18),
- le remplissage dudit moule (18) avec ladite résine liquide durcissable (8),
- le durcissement de ladite résine liquide (8), et
- le retrait desdits éléments de maintien (14, 16) desdites zones de branchement (10, 12).

2. Procédé de la revendication 1, **caractérisé en ce que** ladite encoche permet à ladite résine (8) de couler dans des espaces définis entre lesdites première et deuxième couches conductrices (2a, 2b) et/ou entre les bords latéraux (24) desdites première et deuxième couches conductrices et au moins une des surfaces internes (24) dudit moule (18).

3. Procédé selon l'une quelconque des revendications précédentes **caractérisé en ce que** chacun desdits premier et deuxième éléments de maintien (14, 16) comprend un corps de base en forme de bloc (14c) avec des surfaces latérales lisses (14d, 16d) qui sont situées entre lesdites poches de réception (14a, 14b), dans lequel lesdites surfaces latérales (14d, 16d), après durcissement de ladite résine (8), définissent des surfaces latérales de ladite barre de distribution polyphasée (1) depuis lesquelles se projettent les zones de branchement (12) des première et deuxième couches conductrices (2a, 2b).

4. Procédé selon l'une quelconque des revendications précédentes **caractérisé en ce que** ledit moule (18) est recouvert d'un couvercle (18a) et l'espace intérieur dudit moule (18) est relié à une source de vide pour retirer l'air en excès de ladite résine liquide pendant le remplissage avec et/ou le durcissement de ladite résine (8).

5. Procédé selon l'une quelconque des revendications précédentes **caractérisé en ce que** ladite résine (8) est exposée à des vibrations ultrasonores pendant le durcissement de ladite résine (8) et/ou ledit moule (18) est pivoté vers l'arrière et vers l'avant latéralement pour retirer l'air encapsulé de ladite résine liquide (8) dans ledit moule (18).

6. Procédé selon l'une quelconque des revendications précédentes **caractérisé en ce qu'une** force de support est appliquée à ladite première broche conductrice (4a) et/ou ladite deuxième broche conductrice (4b) pour supporter lesdites première et/ou deuxième couches conductrices (2a, 2b) pendant le durcissement de ladite résine (8) dans ledit moule (18).

7. Procédé selon l'une quelconque des revendications précédentes **caractérisé en ce que** lesdits premier et deuxième éléments de maintien (14, 16) sont recouverts avec ou constitués d'un matériau repoussant la résine.

8. Procédé de la revendication 7 **caractérisé en ce que** lesdits premier et deuxième éléments de maintien (14, 16) sont constitués de et/ou recouverts avec du caoutchouc de silicone.

9. Agencement servant à réaliser le procédé selon l'une quelconque des revendications précédentes comprenant
- une première couche conductrice (2a) constituée d'une tôle, une première broche conductrice (4a) montée sur ladite première couche conductrice (2a) qui s'étend dans une direction perpendiculaire à la première couche conductrice, une deuxième couche conductrice (2b) constituée d'une tôle, ladite deuxième couche conductrice comprenant une première ouverture (6a) à travers laquelle se projette ladite première broche conductrice, une deuxième broche conductrice (4b) qui s'étend dans une direction parallèle à ladite première broche conductrice ;
- un premier élément de maintien (14) ayant un corps de base (14c) avec au moins deux poches de réception en forme de fente (14a, 14b) formées à l'intérieur qui sont adaptées pour recevoir une première zone de branchement (10) desdites première et deuxième couches conductrices (2a, 2b) constituées d'une tôle ;
- un deuxième élément de maintien (16) ayant un corps de base (16c) avec au moins deux poches de réception en forme de fente (16a, 16b) formées à l'intérieur qui sont adaptées pour recevoir une deuxième zone de branchement (12) desdites première et deuxième couches conductrices (2a, 2b), chacune desdites première et deuxième couches conductrices (2a, 2b) comprenant lesdites première et deuxième zones de branchement (10, 12) au niveau de ses parties d'extrémité opposées pour brancher électriquement ladite couche conductrice (2a, 2b) à une alimentation électrique et/ou une zone de branchement (10, 12) d'une autre barre de distribution polyphasée (1) ; et
- un moule (18) qui est adapté pour contenir ledit premier élément de maintien (14) et ledit deuxième élément de maintien (16) et lesdites première et deuxième couches conductrices (2a, 2b) disposées entre eux avec leurs première et deuxième zones de branchement (10, 12) insérées dans lesdites poches de réception (10, 12), une encoche (22) étant formée entre une surface interne (24) du moule (18) et les bords latéraux (20) des première et deuxième couches conductrices (2a, 2b),
le moule (18) étant adapté pour être rempli avec une résine liquide durcissable (8), et lesdits premier et deuxième éléments de maintien (14, 16) étant adaptés pour être retirés desdites zones de branchement (10, 12) après durcissement de ladite résine liquide durcissable (8) .

10. Agencement de la revendication 9, **caractérisé en ce que** ledit premier élément de maintien (14) comprend des première et deuxième surfaces latérales opposées (14e) qui sont situées à une distance (d) desdites premières poches de réception (10) et **en ce que** ledit deuxième élément de maintien (14) comprend des première et deuxième surfaces latérales opposées (16e) qui sont situées à une distance (d) desdites deuxièmes poches de réception (10) dudit deuxième élément de maintien (16).

11. Agencement de la revendication 9 ou 10, **caractérisé en ce que** chacun desdits premier et deuxième éléments de maintien (14, 16) comprend un corps de base en forme de bloc (14c, 16c) avec des surfaces latérales lisses (14e, 16e) qui sont situées entre lesdites poches de réception (14a, 14b), chacune desdites surfaces latérales lisses (14e, 16e) définissant une surface de formation de résine.

12. Agencement de l'une quelconque des revendications 9 à 11, **caractérisé en ce que** chaque poche de réception (14a) dudit premier élément de maintien (14) et/ou chaque poche de réception (16a) dudit deuxième élément de maintien (16) sont scellées par un élément de scellement (26).

13. Barre de distribution polyphasée (1) comprenant une première couche conductrice (2a) constituée d'une tôle, une première broche conductrice (4a) montée sur ladite première couche conductrice (2a) qui s'étend dans une direction perpendiculaire à la première couche conductrice (2a), une deuxième couche conductrice (2b) constituée d'une tôle, ladite deuxième couche conductrice (2b) comprenant une première ouverture (6a) à travers laquelle se projette ladite première broche conductrice (4a), et une deuxième broche conductrice (4b) qui s'étend dans une direction parallèle à ladite première broche conductrice (4a), les première et deuxième couches conductrices (2a, 2b) étant interconnectées mécaniquement l'une à l'autre et isolées électriquement l'une de l'autre par de la résine durcie (8), et chacune desdites première et deuxième couches conductrices (2a, 2b) comprenant une première et une deuxième zone de branchement (10, 12) au niveau de ses parties d'extrémité opposées pour brancher électriquement ladite couche conductrice (2a, 2b) à une alimentation électrique et/ou une zone de branchement (10, 12) d'une autre barre de distribution polyphasée (1), la barre de distribution polyphasée (1) étant produite ou construite par application du procédé selon une des revendications 1 à 8 précédentes.
